# EUROPÄISCHE PATENTSCHRIFT

(11) **EP 0 311 926 B1**
(45) Veröffentlichungstag und Bekanntmachung des Hinweises auf die Patenterteilung: **20.03.1996**
(21) Anmeldenummer: 88116641.7
(22) Anmeldetag: 07.10.1988
(51) Int. Cl.: G03F 7/032, G03F 7/105

(54) **Photopolymerisierbares Gemisch**
Photopolymerisable composition
Composition photopolymérisable

(30) Priorität: 16.10.1987 DE 3735088
(43) Veröffentlichungstag der Anmeldung: 19.04.1989
(73) Patentinhaber: MORTON INTERNATIONAL, INC., Chicago Illinois 60606-1596 (US)
(72) Erfinder: Frommeld, Hans-Dieter, Dr., D-6200 Wiesbaden (DE); Wiezer, Hartmut, Dr., D-6239 Eppstein (DE)
(74) Vertreter: Weber, Dieter, Dr.

(56) Entgegenhaltungen:
- EP-A- 0 063 304
- EP-A- 0 066 870
- US-A- 4 343 885
- US-A- 4 469 520
- DATABASE WPIL, no.82-05065E, Derwent Publications Ltd., London, GB & JP-A-56 159 299

## Beschreibung

Die Erfindung betrifft ein photopolymerisierbares Gemisch, das ein polymeres Bindemittel, eine polymerisierbare Verbindung, einen Photoinitiator, einen Leukofarbstoff und eine Epoxyverbindung enthält.

Solche Gemische ohne Epoxyverbindung sind bekannt. Der Zusatz an Leukofarbstoff bewirkt, daß das Gemisch nach dem Belichten einen sichtbaren Kontrast zwischen belichteten und unbelichteten Bereichen aufweist, da die Leukofarbstoffe während oder nach der Belichtung zu den entsprechenden Farbstoffen oxydiert werden. Solche Gemische sind z. B. in der DE-A-31 31 448 und der EP-A230 941 beschrieben.

Diese Gemische haben die Neigung, sich schon bei der Lagerung im Dunklen zu verfärben, da Leukofarbstoffe auch im Dunklen langsam oxydiert werden. Diese Tendenz tritt verstärkt auf, wenn zur Kontrastverstärkung Photooxydationsmittel, z. B. Trihalogenmethylverbindungen, die beim Belichten Halogenradikale abspalten, zugesetzt werden. Es wurden deshalb für derartige photopolymerisierbare Gemische und Materialien eine Reihe von Stabilisatoren empfohlen, z. B. Schwefelverbindungen, Phenole und andere Reduktionsmittel.

In der DE-A-35 34 527 wird als Stabilisator Thiuramdisulfid beschrieben. Es ist ebenso wie Thioharnstoff ein mäßiges Stabilisierungsmittel. Diese Verbindungen haben den weiteren Nachteil, daß sie mit der Kupferoberfläche reagieren, was sich in Anlauffarben, Schleierbildung beim Entwickeln und Störungen beim anschließenden Galvanisieren äußert. Außerdem setzen Thiuramdisulfide die Lichtempfindlichkeit herab.

In der US-A-3 042 575 werden als Stabilisatoren Phenole wie Resorcin oder Hydrochinon angegeben. Ihre Wirkung ist aber meist unzureichend.

In der DE-A-2 941 846 wird als reduzierender Stabilisator 2,4-Dihydroxy-benzaldoxim genannt, das eine bessere Stabilisierungswirkung hat. Auch bei Zusatz dieser Verbindung ist die Lagerfähigkeit noch nicht ausreichend. Außerdem wird dadurch die Haftung der Schicht auf Kupfer verschlechtert.

Ferner sind aus der EP-A-0 063 304 photopolymerisierbare Gemische der eingangs genannten Zusammensetzung bekannt, die zur Erzielung von Lötstopmasken mit guter Thermoplastizität und guter Beständigkeit im Lötprozeß eine Verbindung mit zwei Epoxygruppen im Molekül enthalten, welche mit dem Bindemittel zu einem interpenetrierenden Netzwerk reagiert.

Die in der US-A-4 343 885 beschriebenen photopolymerisierbaren Gemische enthalten keine Leukofarbstoffe, sondern Fluoranfarbbildner, deren Farbe durch eine Lewis-Säure verstärkt wird. Die in diesen Gemischen enthaltene Epoxyverbindung ist auch ein Vernetzungsmittel für das polymere Bindemittel.

Aufgabe der Erfindung war es, ein photopolymerisierbares Gemisch vorzuschlagen, das bei Belichtung einen guten Farbkontrast ergibt, zugleich eine gute Haftung auf Metall-, insbesondere Kupferoberflächen aufweist und sich bei der Lagerung im Dunklen nicht verfärbt.

Erfindungsgemäß wird ein photopolymerisierbares Gemisch vorgeschlagen, das als wesentliche Bestandteile
a) ein polymeres Bindemittel,
b) eine Verbindung mit mindestens einer endständigen ethylenischen Doppelbindung und einem Siedepunkt bei Normaldruck oberhalb 100° C, die durch radikalisch initiierte Polymerisation ein Polymeres zu bilden vermag,
c) einen Photoinitiator,
d) einen Leukofarbstoff und
e) eine Epoxyverbindung enthält

Das erfindungsgemäße Gemisch ist dadurch gekennzeichnet, daß es als Stabilisator für den Lenkofarbstoff eine Monoepoxyverbindung enthält.

Die Epoxyverbindungen sollen nicht oder praktisch nicht flüchtig sein. Ihr Molekulargewicht sollte jedoch vorzugsweise nicht größer als 600, insbesondere nicht größer als 400 sein.

Geeignet sind z. B. Glycidylether von aliphatischen und aromatischen Verbindungen, z. B. der Monoglycidylether des 2,2-Bis-(4-hydroxyphenyl)-propans, Phenylglycidylether, tert.-Butylphenylglycidylether, p-Methoxyphenylglycidylether, 2-Ethylhexylglycidylether oder das Styroloxid. Besonders bevorzugt sind Verbindungen mit mindestens einem aromatischen Ring im Molekül, z. B. die Arylglycidylether. Die Epoxide werden vorzugsweise in Mengen von 0,05 bis 2 Gew.-%, bezogen auf die nichtflüchtigen Bestandteile des Gemischs, zugesetzt.

Bevorzugte Leukofarbstoffe sind solche der Triphenylmethan- oder Xanthenreihe. Beispiele sind die Leukobasen von Kristallviolett, Victoriablau BH, Victoriareinblau BOH, Methylviolett, Fuchsin, Malachitgrün, Acid Violet 5B, Solar Cyanine 6B, Brilliantgrün und Acilanviolett S. Besonders bevorzugt werden Tris(p-dimethylamino-phenyl)methan, Tris-(p-diethylaminophenyl)methan, Tris-(p-dipropylamino-phenyl)methan und 3,6-Bis-diethylamino-9-phenyl-xanthen.

Als Photoinitiatoren können Benzophenon, Michlers Keton, Thioxanthon, p-Dialkylamino-benzoesäureester und bevorzugt Heterocyclen mit 2 bis 5 aromatischen Ringen und mindestens einem Stickstoffatom als Heteroatom, insbesondere Acridin-, Phenazin- und Chinolinderivate eingesetzt werden.

Zu nennen sind: 9-(4'-Tolyl)-acridin, 9-(4'-Methoxyphenyl)-acridin, 9-(4'-Hydroxyphenyl)-acridin, 9-Acetylamino-acridin, 9,10-Dimethyl-benz[a]phenazin, 10-Methyl-benz[a]phenazin, 9-Methoxy-benz[a]phenazin, 10-Methoxy-benz[a]phenazin, Dibenz[a,c]phenazin, 11 -Methoxy-dibenz[a,c]-phenazin, Dibenz[a,j]phenazin, insbesondere 9-Phenylacridin, 9-(4'-t-Butylphenyl)-acridin, Benz[a]phenazin, 9-Methyl-benz[a]phenazin, 2-Styryl-chinolin, Cinnamylidenchinaldin und 3-(o-Chlor-benzyliden)-9-phenyl-2,3-dihydro-1Hcyclopenta [b]chinolin.

Die Menge des Photoinitiators beträgt im allgemeinen 0,01 bis 10, bevorzugt 0,05 bis 4 Gew.-%, bezogen auf die nichtflüchtigen Bestandteile des Gemischs.

Vorzugsweise enthält das Gemisch außerdem ein Photooxydationsmittel, insbesondere eine Verbindung mit mindestens einem Trihalogenmethylsubstituenten oder einer dihalogenierten Methylengruppe im Molekül.

Von diesen Verbindungen sind insbesondere Tribrommethylphenylsulfon, 2,2-Dibrommalonsäurebisamid, α,α-Dibromα-cyanomethyl-phenylsulfon, α,α-Dibrom-α-benzoyl-methylphenylsulfon, α,α-Dibrommalonsäure-bis-N-methylamid, 4,6-Bis(trichlormethyl)-s-triazine oder 2-Tribrommethylchinolin anzuwenden, wobei von den 4,6-Bis(trichlormethyl)-s-triazinen vorzugsweise die in 2-Stellung substituierten Derivate in Frage kommen. Als Substituenten werden insbesondere Methyl-, Ethyl-, Phenyl-, 4-Methoxyphenyl- oder 4'-Styrylphenyl- eingesetzt. Tribrommethyl-phenylsulfon wird besonders bevorzugt. Das Photooxydationsmittel wird vorzugsweise in einer Menge von 0,01 bis 2 Gew.-% eingesetzt.

Für die Erfindung geeignete polymerisierbare Verbindungen mit mindestens einer endständigen ethylenischen Doppelbindung sind bekannt und z. B. in den US-A-2 760 863 und 3 060 023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A-20 64 079, 23 61 041 und 28 22 190 beschrieben.

Der Mengenanteil der Schicht an Monomeren beträgt im allgemeinen etwa 10 bis 80, vorzugsweise 20 bis 60 Gew.-%.

Als polymeres Bindemittel kann eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Mit besonderem Vorteil werden polymere Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: -COOH, -PO₃H₂, -SO₃H; -SO₂NH-, -SO₂-NH-SO₂- und -SO₂-NH-CO-.

Als Beispiele hierfür seien genannt: Maleinatharze, Polymerisate aus N-(p-Tolyl-sulfonyl)-carbaminsäure-β(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkyl(meth)acrylat/Methacrylsäure-Mischpolymerisate und Mischpolymerisate aus Methacrylsäure, höheren Alkyl(meth)acrylaten und Methylmethacrylat und/oder Styrol, Acrylnitril u. a., wie sie in den DE-A-20 64 080 und 23 63 806 beschrieben sind, werden bevorzugt.

Die Menge des Bindemittels beträgt im allgemeinen 20 bis 90, vorzugsweise 40 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind:

Haftvermittler, Inhibitoren zur Verhinderung der thermischen Polymerisation der Monomeren, Wasserstoffdonatoren, die sensitometrischen Eigenschaften derartiger Schichten modifizierende Stoffe, Farbstoffe, gefärbte und ungefärbte Pigmente, Weichmacher, z. B. Polyglykole oder Ester der p-Hydroxybenzoesäure.

Beispiele für geeignete Zusätze sind Schwefelverbindunggen, wie Mercaptobenzimidazol, Mercaptobenzthiazol, Imidazol oder Imidazolderivate, Verbindungen mit dreiwertigem Phosphor wie Triphenylphosphin oder Triphenylphosphit.

Diese Bestandteile sind zweckmäßig so auszuwählen, daß sie in dem für den Initiierungsvorgang wichtigen aktinischen Strahlungsbereich möglichst wenig absorbieren.

Das photopolymerisierbare Gemisch kann für die verschiedensten Anwendungen Einsatz finden, beispielsweise zur Herstellung von Lacken, die durch Licht gehärtet werden, und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, verwendbar. Besondere Bedeutung haben die erfindungsgemäßen Gemische für die Photoresisttechnik, insbesondere als Trockenphotoresistmaterialien.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschicnteten lichtempfindlichen Kopiermaterials, z. B. für die Herstellung von Druckformen, vorliegen. Ebenso ist es für die Herstellung von Trockenresist geeignet.

Als Schichtträger für mit dem erfindungsgemäßen Gemisch hergestellte Kopiermaterialien sind beispielsweise Aluminium, Stahl, Zink, Kupfer und Kunststoff-Folien, z. 3. aus Polyethylenterephthalat oder Cellulosacetat, sowie Siebdruckträger, wie Perlongaze, geeignet.

Die Herstellung der lichtempfindlichen Materialien unter Verwendung des erfindungsgemäßen Gemischs erfolgt in bekannter Weise.

So kann man dieses in einem Lösungsmittel aufnehmen und die Lösung bzw. Dispersion durch Gießen, Sprühen, Tauchen, Antrag mit Walzen usw. auf den vorgesehenen Träger als Film antragen und anschließend antrocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und angetrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Die Verarbeitung der Materialien wird in bekannter Weise vorgenommen. Die Bebilderung erfolgt durch Belichten mit aktinischer Strahlung. Als aktinische Strahlung soll im Rahmen dieser Beschreibung jede Strahlung verstanden werden, deren Energie mindestens der des kurzwelligen sichtbaren Lichts entspricht. Geeignet ist langwellige UV-Strahlung, aber auch Laserstrahlung. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der photopolymerisierbaren Schicht auf dem Träger zurückbleiben.

Die folgenden Beispiele erläutern bevorzugte Ausführungsformen der Erfindung. Mengenverhältnisse und Prozentzahlen sind in Gewichtseinheiten zu verstehen. Die Mengen an Bestandteilen sind in Gewichtsteilen (Gt) angegeben.

### Beispiel 1

Die folgenden Lösungen 1 a bis 1 l wurden hergestellt, indem jeweils einer Grundlösung aus
- 50 Gt: des Umsetzungsproduktes aus 1 mol 2,2,4-Trimethylhexamethylendiisocyanat und 2 mol 2-Hydroxy-ethylmethacrylat,
- 50 Gt: eines Terpolymerisats aus Styrol, n-Hexylmethacrylat und Methacrylsäure (10:60:30) mit der Säurezahl 190,
- 0,05 Gt: Viktoriareinblau FGA (CI Basic Blue 81),
- 0,2 Gt: Phenyl-tribrommethylsulfon,
- 0,9 Gt: Leukokristallviolett sowie
- 0,35 Gt: 9-Phenyl-acridin in
- 100 Gt: Butanon und
- 20 Gt: Ethanol
die folgenden Bestandteile zugesetzt wurden:
Lösung
- 1 a (V):: kein Zusatz
- 1 b (V):: 0,5 Gt Resorcin
- 1 c (V):: 0,5 Gt Hydrochinon
- 1 d (V):: 0,5 Gt Thioharnstoff
- 1 e (V):: 0,5 Gt Tetramethylthiuramdisulfid
- 1 f (V):: 0,5 Gt Diacetyldioxim
- 1 g (V):: 0,5 Gt 2,4-Dihydroxy-benzaldoxim
- 1 h (V):: 0,5 Gt Ascorbinsäure
- 1 i :: 0,5 Gt 2,2-Bis-(p-hydroxyphenyl)-propan-mono-2,3-epoxypropylether
- 1 k :: 0,5 Gt 2,3-Epoxypropyl-p-t-butylphenylether
- 1 l :: 0,5 Gt 2,3-Epoxypropyl-2'-ethylhexylether

### V = Vergleichsversuch

Die Lösungen wurden jeweils auf 25 µm starke Polyethylenterephthalatfolie aufgebracht. Anschließend wurde 2 Minuten bei 100° C im Trockenschrank getrocknet. Es wurden Trockenresistschichten mit 45 g/m Schichtgewicht erhalten.

Um die Trockenresistschichten vor Verschmutzung durcn Staub und Beschädigungen zu schützen, wurden sie mit einer 20 µm starken Deckfolie aus Polyethylen abgedeckt, die an der photopolymerisierbaren Schicht weniger stark haftet als die Polyesterfolie.

Zur Bestimmung der Lagerfähigkeit wurden die Schichten 10 Tage bei 40° C gelagert. Mit einem Hunterlab-Farbmeßgerät wurden die Helligkeiten in Remission vor und nach der Lagerung gemessen. Der L-Wert ist ein Maß für die Helligkeit (100 = ideales Weiß, 0 = ideales Schwarz). Die L-Werte sind für die verschiedenen Gemische in Tabelle 1 zusammengestellt.

Zur Bestimmung von Lichtempfindlichkeit und Haftung wurden, nach Abziehen der Deckfolie, die Trockenresistschichten mit Hilfe eines handelsüblichen Laminators bei 120° C und mit einer Geschwindigkeit von 1,5 m/Minute auf vorgereinigte Kupferfolie, die mit einem Epoxid-Glasfaser-Hartgewebe kaschiert war, laminiert.

Die Proben 1 a bis 1 l des auf die Kupferoberfläche laminierten Resists wurden anschließend durch die Trägerfolie hindurch unter einer Vorlage belichtet, die ein Linienmuster sowie einen 13-stufigen Halbtonsturenkeil mit Dichteinkrementen von 0,15 enthielt. Belichtet wurde jeweils 5 Sekunden mit einer eisendotierten 5-kW-Metallhalogenidlampe in einem Abstand von 90 cm.

Nach Abziehen der Trägerfolie wurden die belichteten Platten mit 0,8 %iger Sodalösung bei 25° C sprühentwickelt. Die Entwicklungszeit betrug jeweils ca. 60 Sekunden.

Die Zahl der durchgehärteten Stufen ist der folgenden Tabelle zu entnehmen.

Zur Prüfung der Haftung wurde in die unbelichtete Schicht nach dem Laminieren auf Kupferfolie und nach Abziehen der Trägerfolie ein Kreuzschnittmuster eingeritzt. Auf die Resistschicht wurde dann eine handelsübliche Klebefolie gepreßt und mit einem Ruck abgezogen. Kein Ablösen des Resists vom Kupfer wurde mit Haftung + beurteilt, leichtes Ablösen mit 0 und starkes Ablösen mit - beurteilt (s. Tabelle).

Aus der tabellarischen Übersicht wird deutlich, daß die bekannten Stabilisierungsmittel entweder wenig wirksam sind oder andere Nachteile aufweisen. Die erfindungsgemäßen Muster i - l weisen bezüglich Stabilisierung, Lichtempfindlichkeit und Kupferhaftung ein Optimum an Eigenschaften auf.

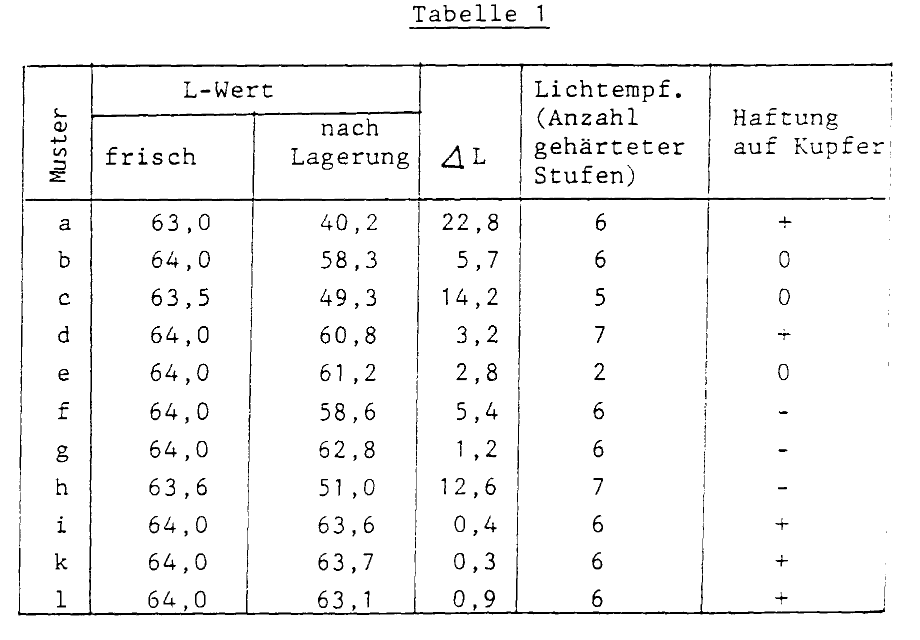

### Beispiel 2

Die folgenden Lösungen 2a bis 2d wurden hergestellt, indem jeweils einer Grundlösung aus
- 54 Gt: eines Terpolymerisats aus Methylmethacrylat, n-Hexylmethacrylat und Methacrylsäure (5 : 60 : 35) mit der Säurezahl 220,
- 23 Gt: des Umsetzungsproduktes aus 1 mol 2,2,4-Trimethyl-hexamethylendiisocyanat und 2 mol 2-Hydroxy-ethylmethacrylat,
- 23 Gt: Triethylenglykoldiacrylat,
- 0,1 Gt: 1,4-Bis-(isopropylamino)anthrachinon,
- 0,5 Gt: 2,2-Dibrommalonsäurediamid,
- 0,5 Gt: Leukokristallviolett,
- 2,0 Gt: Leukomalachitgrün sowie
- 0,2 Gt: 3-p-Acetoxy-benzyliden-9-phenyl-2,3-dihydro1H-cyclopenta[b]chinolin in
- 50 Gt: Butanon und
- 30 Gt: Ethanol
die folgenden Bestandteile zugesetzt wurden:
- 2a: kein Zusatz (Vergleich),
- 2b: 0,5 Gt Hydrochinon (Vergleich),
- 2c: 0,5 Gt 2,4-Dihydroxy-benzaldoxim (Vergleich),
- 2d: 0,5 Gt 4-Methoxyphenyl-2,3-epoxypropylether

### Beispiel 3

Wie in Beispiel 2 wurden die folgenden Lösungen 3a bis 3e hergestellt, indem wieder jeweils einer Grundlösung aus
- 60 Gt: eines Terpolymerisats aus Styrol, n-Hexylmethacrylat und Methacrylsäure (10 : 55 : 35) mit der Säurezahl 220,
- 20 Gt: Triethylenglykoldiacrylat,
- 20 Gt: N-(Isobutoxymethyl)methacrylamid,
- 0,2 Gt: Neozaponblau 807 (C.I. 74.400),
- 0,2 Gt: Cyano-dibrommethyl-phenylsulfon,
- 1,05 Gt: Leukomalachitgrün und
- 0,75 Gt: Isopropylthioxanthon in
- 50 Gt: Butanon und
- 140 Gt: Ethanol
die folgenden Bestandteile zugesetzt wurden:
- 3a: kein Zusatz (Vergleich),
- 3b: 0,25 Gt Hydrochinon (Vergleich),
- 3c: 0,25 Gt 2,4-Dihydroxy-benzaldoxim (Vergleich),
- 3d: 0,25 Gt Phenyl-2,3-epoxypropylether,
- 3e: 0,25 Gt t-Butylphenyl-2,3-epoxypropylether.

Die Lösungen aus Beispiel 2 und 3 wurden analog Beispiel 1 auf 25 µm starke Polyethylenterephthalatfolie aufgebracht und getrocknet (Schichtgewicht 45 g/m). Die Trockenresistschichten wurden dann mit einer 20 µm starken Folie aus Polyethylen abgedeckt.

Nach Abziehen der Deckfolie wurden die Trockenresistschichten mit Hilfe eines handelsüblichen Laminators bei 120° C und mit einer Geschwindigkeit von 1,5 m/Minute auf vorgereinigte Kupferfolie, die mit einem Epoxid-Glasfaser-Hartgewebe kaschiert war, laminiert.

Von jeder der Schichten 2a bis 3e wurde eine Probe als Trockenresistfolie mit Träger- und Deckfolie 7 Tage und eine Probe nach Laminieren auf Kupfer 2 Tage bei 40° C gelagert. Mit einem Hunterlab-Farbmeßgerät wurden die Helligkeiten in Remission vor und nach der Lagerung gemessen.

In der folgenden Tabelle 2 ist der Helligkeitsrückgang (Δ L) der verschiedenen Schichten verzeichnet:

**Tabelle 2**

| Probe | ΔL auf Kupfer | ΔL der Folie |
|---|---|---|
| | | |
| 2a | 5 | 12 |
| 2b | 8 | 2,7 |
| 2c | 11 | 2,3 |
| 2d | 1,5 | 1,0 |
| 3a | 4 | 20 |
| 3b | 2,2 | 7 |
| 3c | 4,5 | 2,5 |
| 3d | 1,0 | 2,0 |
| 3e | 0,8 | 2,0 |

## Patentansprüche

1. Photopolymerisierbares Gemisch, das als wesentliche Bestandteile
a) ein polymeres Bindemittel,
b) eine Verbindung mit mindestens einer endständigen ethylenischen Doppelbindung und einem Siedepunkt bei Normaldruck oberhalb 100 °C, die durch radikalisch initiierte Polymerisation ein Polymeres zu bilden vermag,
e) einen Photoinitiator,
d) einen Leukofarbstoff und
e) eine Epoxyverbindung
enthält, **dadurch gekennzeichnet**, daß es als Stabilisator für den Leukofarbstoff eine Monoepoxyverbindung enthält.

2. Gemisch nach Anspruch 1, **dadurch gekennzeichnet**, daß die Epoxyverbindung ein Glycidylether ist.

3. Gemisch nach Anspruch 1, **dadurch gekennzeichnet**, daß die Epoxyverbindung mindestens einen aromatischen Ring enthält.

4. Gemisch nach Anspruch 1, **dadurch gekennzeichnet**, daß es 0,05 bis 2 Gew.-% Expoxyverbindung, bezogen auf seine nichtflüchtigen Bestandteile, enthält.

5. Gemisch nach Anspruch 1, **dadurch gekennzeichnet**, daß der Leukofarbstoff ein Triphenylmethan- oder Xanthenfarbstoff ist.

6. Gemisch nach Anspruch 1, **dadurch gekennzeichnet**, daß es zusätzlich ein Photooxydationsmittel enthält.

7. Gemisch nach Anspruch 6, **dadurch gekennzeichnet**, daß das Photooxydationsmittel eine Verbindung mit mindestens einem Trihalogenmethylsubstituenten oder einer dihalogenierten Methylengruppe ist.

8. Photopolymerisierbares Aufzeichnungsmaterial mit einem Schichtträger und einer photopolymerisierbaren Schicht, **dadurch gekennzeichnet**, daß die Schicht aus einem Gemisch gemäß einem der Ansprüche 1 bis 7 besteht.

## Claims

1. Photopolymerizable mixture which contains, as essential components
a) a polymeric binder,
b) a compound which has at least one terminal ethylenic double bond and a boiling point above 100°C at atmospheric pressure and which is capable of forming a polymer by free radical polymerization,
e) [sic] a photoinitiator,
d) a leuco dye and
e) an epoxy compound
characterized in that it contains a monoepoxy compound as a stabilizer of the leuco dye.

2. Mixture according to Claim 1, characterized in that the epoxy compound is a glycidyl ether.

3. Mixture according to Claim 1, characterized in that the epoxy compound contains at least one aromatic ring.

4. Mixture according to Claim 1, characterized in that it contains 0.05 to 2% by weight of epoxy compound, based on its nonvolatile components.

5. Mixture according to Claim 1, characterized in that the leuco dye is a triphenylmethane or xanthene dye.

6. Mixture according to Claim 1, characterized in that it additionally contains a photooxidizing agent.

7. Mixture according to Claim 6, characterized in that the photooxidizing agent is a compound having at least one trihalomethyl substituent or one dihalogenated methylene group.

8. Photopolymerizable recording material having a substrate and a photopolymerizable layer, characterized in that the layer consists of a mixture according to any of Claims 1 to 7.

## Revendications

1. Mélange photopolymérisable, qui contient comme constituants essentiels:
a) un liant polymère,
b) un composé comportant au moins une double liaison éthylénique terminale et ayant un point d'ébullition, sous la pression normale, supérieur à 100°C et qui peut former un polymère par polymérisation à amorçage radicalaire,
c) un photoamorceur,
d) un leucodérivé de colorant, et
e) un époxyde,
mélange caractérisé en ce qu'il contient un monoépoxyde comme stabilisant du leucodérivé de colorant.

2. Mélange selon la revendication 1, caractérisé en ce que l'époxyde est un éther glycidylique.

3. Mélange selon la revendication 1, caractérisé en ce que l'époxyde contient au moins un noyau aromatique.

4. Mélange selon la revendication 1, caractérisé en ce qu'il contient 0,05 à 2 % en poids d'un époxyde, par rapport à ses constituants non volatils.

5. Mélange selon la revendication 1, caractérisé en ce que le leucodérivé de colorant est un produit dérivant d'un colorant de la série du triphénylméthane ou du xanthène.

6. Mélange selon la revendication 1, caractérisé en ce qu'il contient en outre un agent de photo-oxydation.

7. Mélange selon la revendication 6, caractérisé en ce que l'agent de photo-oxydation est un composé comportant au moins un substituant trihalogénométhyle ou un groupe méthylène dihalogéné.

8. Matériau d'enregistrement photopolymérisable comportant un support de couche et une couche photopolymérisable, matériau caractérisé en ce que la couche consiste en un mélange selon l'une des revendications 1 à 7.
